Europäisches Patentamt

European Patent Office

Office européen des brevets

(11) Veröffentlichungsnummer: **0 529 259 A1**

## (12) EUROPÄISCHE PATENTANMELDUNG

(21) Anmeldenummer: **92111748.7**

(22) Anmeldetag: **10.07.92**

(51) Int. Cl.⁵: **H01J 37/34**, C23C 14/34

(30) Priorität: **17.08.91 DE 4127317**

(43) Veröffentlichungstag der Anmeldung:
**03.03.93 Patentblatt 93/09**

(84) Benannte Vertragsstaaten:
**BE CH DE ES FR GB IT LI LU NL SE**

(71) Anmelder: **LEYBOLD AKTIENGESELLSCHAFT**
**Wilhelm-Rohn-Strasse 25, Postfach 1555**
**W-6450 Hanau am Main 1(DE)**

(72) Erfinder: **Fritsche, Wolf-Eckart,**
**Dipl.-Ing.(Phys.)**
**Hanauer Strasse 47**
**W-8752 Kleinostheim(DE)**

(74) Vertreter: **Schickedanz, Willi, Dipl.-Ing.**
**Langener Strasse 68**
**W-6050 Offenbach/Main (DE)**

(54) Einrichtung zum Behandeln von Substraten.

㊷ Die Erfindung betrifft eine Einrichtung zum Behandeln von Substraten aus einem Plasma, mit wenigstens einer Anode, einer Kathode und einer elektrischen Gleichstrom-Spannungsquelle, die impulsweise an die Anoden-Kathoden-Strecke anschließbar ist. Die Dauer der Spannungsimpulse und/oder der Abstand zwischen den Impulsen ist regelbar.

FIG.5

EP 0 529 259 A1

Die Erfindung betrifft eine Einrichtung zum Behandeln von Substraten nach dem Oberbegriff des Patentanspruchs 1.

Bei der Beschichtung von Substraten im Sputterverfahren ist es bisweilen erforderlich, verschiedenartige Schichtmaterialien auf dem Substrat unter-oder übereinander aufzubringen. Hierzu müssen entweder nacheinander verschiedene Targets an einer Kathode angebracht werden oder es müssen mehrere Kathoden mit jeweils unterschiedlichen Targets versehen sein.

Werden mehrere Substrate nacheinander durch eine Sputteranlage gefahren, um sie zu beschichten, so treten erhebliche Probleme dadurch auf, daß die Sputterraten verschiedener Targetmaterialien unterschiedlich sind. Metalle weisen z. B. eine wesentliche höhere Sputterrate auf als reaktiv gesputterte Metalloxide oder -nitride. Sollen auf einem Substrat Schichtsysteme mit übereinander angeordneten Sputterschichten erzeugt werden, etwa in der Reihenfolge Haftvermittler - Metall - erstes Dielektrikum - zweites Dielektrikum, so muß die konstante Geschwindigkeit, mit der das Substrat durch die Anlage befördert wird, auf die niedrigste Sputterrate abgestimmt werden, d h. die Geschwindigkeit ist so anzulegen, daß sich bei der niedrigsten Sputterrate die notwendige Schichtdicke des gesputterten Materials aufbaut.

Eine Möglichkeit, die Transportgeschwindigkeit des Substrats zu erhöhen, könnte darin bestehen, die elektrische Leistung, mit der die Sputterkathode betrieben wird, an das jeweilige Targetmaterial anzupassen. Allerdings kann diese Leistung nicht beliebig reduziert werden, weil sonst das Plasma erlischt, aus dem heraus die Ablagerung des gesputterten Materials auf dem Substrat erfolgt.

Außerdem sind die Schichteigenschaften von der Sputterspannung und damit von der Leistung der Kathode abhängig, mit der die Schicht auf das Substrat aufgebracht wird, so daß auch aus diesem Grund die Leistung der Kathode nicht beliebig verändert werden kann.

Um diese Schwierigkeit zu umgehen, könnte man die Anzahl der Targets mit der geringsten Sputterrate und damit die Zahl der zugehörigen Kathoden relativ zu den anderen Kathoden erhöhen. Eine solche Maßnahme würde jedoch die gesamte Sputteranlage sehr verteuern.

In der bisherigen Praxis ist man deshalb so vorgegangen, daß vor die Kathoden Blenden gesetzt wurden, die soweit geschlossen wurden, bis die erwünschte Sputterrate erreicht war. Dies hatte aber zur Folge, daß die Blenden stark beschichtet wurden und häufig gereinigt werden mußten.

Es ist bereits ein Verfahren zum schonenden Beschichten elektrisch leitender Gegenstände nach dem PVD-Verfahren mittels ionisierter Dämpfe aus dem Gleichspannungsplasma einer Glimmentladung bekannt, bei dem die elektrische Energie mit periodisch wiederholten Gleichstromimpulsen erfolgt (DE-C1-37 00 633). Die Impulse weisen dabei eine Spannung von mehr als 100 V auf, insbesondere zwischen 200 und 800 V. Sie vermögen innerhalb der Vakuumkammer ein Plasma aufrechtzuerhalten, das einerseits die Gefahr der Bildung von Lichtbögen weitgehend ausschließt und andererseits aber auch ein wirksames Beschichten von Gegenständen erlaubt.

Dieses bekannte Verfahren kann auch bei Anlagen mit einem Magnetron verwendet werden. Die besondere Schwierigkeit, die sich bei Sputterverfahren mit verschiedenen Sputtermaterialien ergeben, werden indessen nicht behoben.

Es ist weiterhin eine Einrichtung zum stabilen Betrieb mehrerer Plasmatrons zum Hochratenzerstäuben bekannt, bei der mehrere gepulst arbeitende Plasmatrons vorgesehen sind (DD-A3-271 827). Beispielsweise stehen sich zwei gepulst betriebene Plasmatrons im Abstand von etwa 100 mm gegenüber, durch die zu beschichtende Werkzeuge bewegt werden. Beide Plasmatrons werden hierbei von derselben Stromversorgungseinrichtung gespeist, die für den Leistungsbereich von 70 kW ausgelegt ist. Zur Stromversogung gehört eine schnelle, kontaktlos arbeitende Umschalteinrichtung für hohe Ströme. Mit dieser bekannten Einrichtung kann zwar ein stabiler Betrieb trotz pulsweisen Betriebs mehrerer Plasmatrons erzielt werden, es ist jedoch nicht möglich, die Beschichtungsraten bei verschiedenen Sputtermaterialien einzustellen.

Der Erfindung liegt deshalb die Aufgabe zugrunde, bei Substraten, die beim Gleichstromsputtern an mehreren Sputterkathoden vorbeibewegt werden, um sie mit verschiedenartigen Schichten zu versehen, die Beschichtungsrate exakt einstellen zu können.

Diese Aufgabe wird gemäß den Merkmalen des Patentanspruchs 1 gelöst.

Der mit der Erfindung erzielte Vorteil besteht insbesondere darin, daß die Geschwindigkeit, mit der Substrate beschichtet werden, von äußeren Bedingungen, z. B. der Substratvorschubgeschwindigkeit oder der Sputterrate der langsamsten Kathode, unabhängig sind. Hierbei wird die Sputterkathode in einen Betriebszustand gebracht, der bei geringer Sputterrate trotzdem die Teilchen mit erhöhter Energie sputtert, um die gewünschten Schichteigenschaften zu erzielen.

Die Erfindung ist somit besonders zum Sputtern von möglichst niedrigen Beschichtungsraten geeignet. Besonders vorteilhaft ist es, wenn mit jeweils einer Stromversorgung jeweils eine Sputterkathode betrieben wird, wobei die in die Kathode eingebrachte Leistung durch Unterbrechung reduziert wird, d. h. durch Takten wird über eine zeitliche Mittelung die Leistung erniedrigt.

Ausführungsbeispiele der Erfindung sind in der Zeichnung dargestellt und werden im folgenden näher beschrieben. Es zeigen:

Fig. 1 eine graphische Darstellung der Spannung an einer Sputterkathode in Abhängigkeit von der Zeit;

Fig. 2 eine graphische Darstellung des Sputterstroms über der Zeit;

Fig. 3 eine graphische Darstellung der Spannung an der Kathode bei verschiedenen Ein- und Ausschaltimpulsen;

Fig. 4 eine weitere graphische Darstellung der Spannung an der Kathode zu verschiedenen Zeiten;

Fig. 5 eine schematische Darstellung einer Sputteranlage mit linear bewegten Substraten.

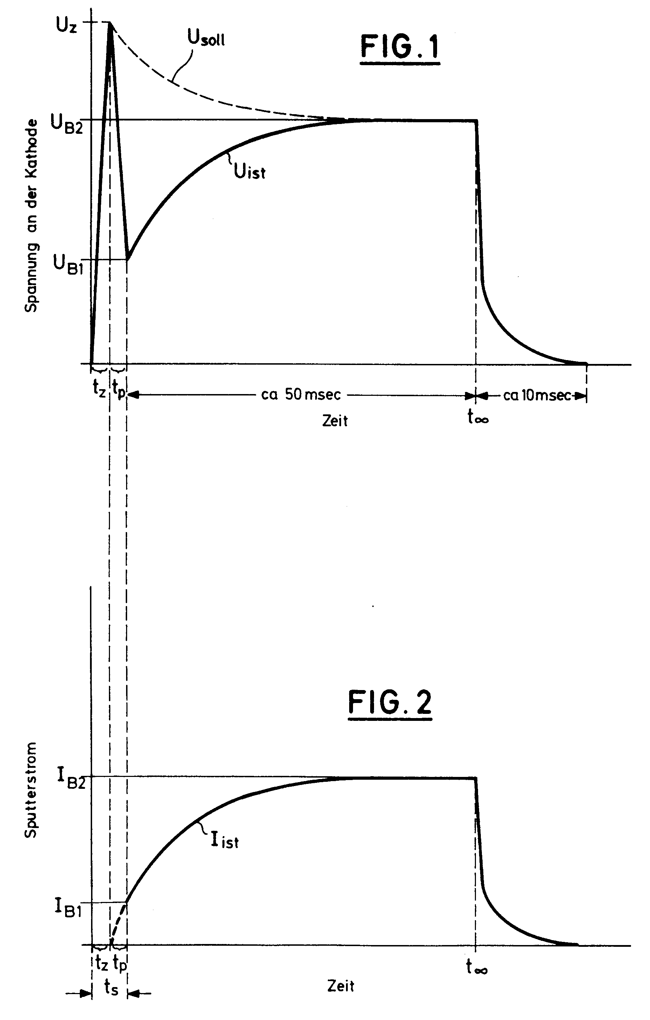

In der Fig. 1 ist der Verlauf der Spannung an einer Kathoden-Anoden-Strecke einer Sputteranlage über der Zeit dargestellt. Nach dem Einschalten einer Gleichspannungsversorgung baut sich an der Elektrode der Sputteranlage die Spannung innerhalb einer Zeit $t_z$ auf die Zündspannung $U_z$ auf. Erst ab diesem Spannungswert $U_z$ kann ein Plasma gezündet werden. Die Zeit $t_z$ beträgt in der Praxis etwa 0,5 bis 6 Mikrosekunden und ist durch die Zeitkonstante der elektronischen Beschaltung der Sputterkathoden-Stromversorgung bedingt. Nun vergeht noch eine Plasma-Entstehungszeit $t_p$, bis sich genügend Ladungsträger im ionisierten Gas gebildet haben, um eine Gasentladung zu erzeugen. Diese Zeit wird durch verschiedene Größen bestimmt, z. B. durch die Zeit, die vergeht, bis das erste Elektronen/Ionenpaar erzeugt wird, durch die Spannung, die im Moment des Zündens an Anode und Kathode liegt, durch den Wirkungsquerschnitt, der die Wahrscheinlichkeit darstellt, mit derein Stoß zwischen Elektron und Atom bzw. Ion und Atom geschieht, der zur Ionisation führt, durch den Koeffizienten der Sekundärelektronemission der Targetoberfläche, durch den Druck und damit die mittlere freie Weglänge sowie durch die Geometrie der Sputterapparatur, die einen Einfluß auf die Weglänge eines Teilchens hat.

In dem entstehenden Plasma sind Ladungsträger vorhanden, die an einer Elektrode abfließen. Hierdurch fließt ein Entladungsstrom, so daß die Spannung der Sputterstromversorgung zusammenbricht und auf einen Wert $U_{B1}$ fällt. Der Entladestrom, der während der Zeit $t_p$ fließt, ist in der Fig. 2 näher dargestellt. Aufgrund der Regelungskonstanten kann innerhalb der Zeit $t_p$ nur die maximale Stromstärke $I_{B1}$ geliefert werden.

Die Spannung $U_{B1}$ charakterisiert bereits ein stabiles Plasma, bei dem sich ein gewisses elektrisches Gleichgewicht eingestellt hat. Nachdem die Spannung ihren Tiefstwert $U_{B1}$ angenommen hat, steigt sie allmählich wieder an, und zwar bis aufeinen Wert $U_{B2}$ zur Zeit $t_\infty$. Bei dieser Spannung $U_{B2}$ handelt es sich um die Brennspannung, die sowohl durch die physikalischen Einflüsse des Plasmas bestimmt wird als auch durch den an der Regelung der Stromversorgung vorgewählten Sollwert $U_{soll}$. Bei Zeiten länger als $t_\infty$ ändert sich nichts mehr an der Spannung der Entladung. Der Spannungswert $U_{B2}$ wird dadurch erreicht, daß die lieferbare Stromstärke mit einer bestimmten zeitlichen Regelkonstanten auf den Wert $I_{B2}$ ansteigt.

Zum Zünden des Plasmas ist, wie bereits erwähnt, die Spannung $U_z$ nötig, d. h. der Spannungssollwert bzw. die bereitgestellte Klemmenspannung müßte beim Einschalten diesen Wert $U_z$ erreichen oder überschreiten. Würde die Spannungsversorgung nun weiterhin die Spannung $U_z$ bereitstellen, so wäre keine Regelung der Gasentladung mehr möglich, und sie würde mit voller Nennleistung arbeiten.

Um dies zu verhindern, wird innerhalb der Zeit $t_\infty$, in welcher der Entladestrom den Endwert $I_{B2}$ erreichen kann, der Spannungssollwert $U_{soll}$ von $U_z$ auf $U_{B2}$ abgesenkt.

Die Spannung $U_{B2}$ ergibt sich somit einerseits durch das Ansteigen der Spannung $U_{ist}$ an der Anoden-Kathoden-Strecke auf $U_{B2}$ und andererseits durch das Absenken der Klemmenspannung von $U_z$ auf $U_{B2}$.

Wird die Spannungsversorgung zum Zeitpunkt $t_\infty$ abgeschaltet, fällt die Anoden-Kathoden-Spannung mit einer Zeitkonstanten von ca. 10 ms ab, wobei diese Zeitkonstante von der elektrischen Beschaltung der Spannungsversorgung abhängt.

Aus den Kurven gemäß Fig. 1 und 2 ergibt sich somit, daß der eigentliche Sputtervorgang nach der Zeit $t_s = t_z + t_p$ beginnt, weil erst nach dieser Zeit $t_s$ eine gewisse Stabilisierung des Plasmas eingesetzt hat.

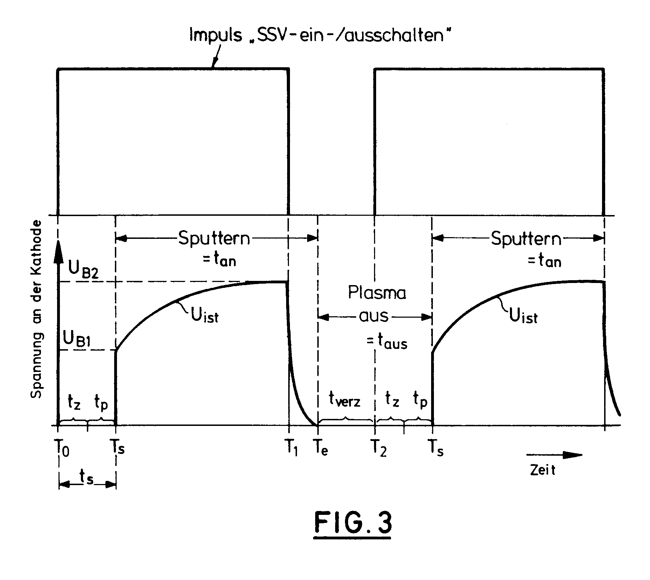

In der Fig. 3 ist die Istspannung an der Kathode bei einem Impulsbetrieb dargestellt. Die Zeitpunkte sind hierbei mit Großbuchstaben bezeichnet, während die Zeitspannen mit Kleinbuchstaben bezeichnet sind.

Zum Zeitpunkt $T_0$ wird die Spannungsversorgung eingeschaltet, und zum Zeitpunkt $T_1$ wird sie wieder ausgeschaltet.

Nach dem Einschalten der Spannungsversorgung vergeht zunächst die Zeitspanne $t_s$, bis der Sputterprozeß im Zeitpunkt $T_s$ einsetzt. Die Sputterleistung steigt bis zum Zeitpunkt $T_1$, der mit dem Zeitpunkt $t_\infty$ aus Fig. 1, 2 vergleichbar ist, aus den oben beschriebenen Gründen auf den Maximalwert $U_{B2}$ an. Wird nun die Spannungsversorgung im Zeitpunkt $T_1$ abgeschaltet, klingt der Sputterprozeß bis spätestens zum Zeitpunkt $T_e$ auf Null ab.

Erfindungsgemäß wird die Spannungsversorgung erst nach einer Verzögerungszeit $t_{verz}$ zum

Zeitpunkt $T_2$ wieder eingeschaltet. Die Beschichtungszeit oder Sputterzeit ergibt sich hierdurch zu $t_{an} = T_e - T_s$, während sich die Nichtbeschichtungszeit zu $t_{aus} = t_{verz} + t_z + t_p = t_{verz} + t_s$ ergibt. Der Sputterprozeß wird somit vom Zeitpunkt $T_e$ bis zum Zeitpunkt $T_s$ unterbrochen, um beim erneuten Zünden mit dem nächsten Impuls bei $T_s$ wieder mit dem Sputtern zu beginnen.

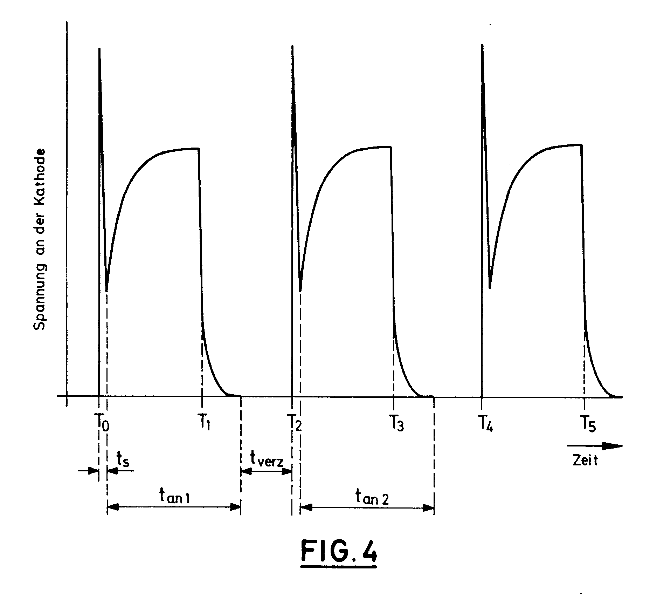

In der Fig. 4 ist der zeitliche Verlauf der Kathodenspannung bei mehreren Ansteuerimpulsen der Spannungsversorgung dargestellt. Da die Zeit $t_s$ physikalisch vorgegeben ist, kann die festlegbare Verzögerungszeit $t_{verz}$ zu Regelungszwecken verwendet werden.

Es ist zu beachten, daß die Nichtbeschichtungszeit $t_z + t_p + t_{verz}$ kurz genug gewählt wird, damit die aufgetragene Schicht nicht in zu starker Welligkeit erzeugt wird. Angenommen, man wählt die Taktpause, d. h. die Nichtbeschichtungszeit so groß, daß das Substrat in dieser Zeit zur Hälfte an der Kathode vorbeigefahren ist, bis die nächste Beschichtung einsetzt, so wäre das Substrat zur Hälfte beschichtet und zur Hälfte unbeschichtet. Verkürzt man nun die Pausenzeit, so schieben sich zwei aufeinanderfolgende Beschichtungen immer mehr zusammen, bis sie sich überlappen. Überlappung ist aber gleichbedeutend mit der Tatsache, daß ein Teil des Substrats zweimal beschichtet wird, während andere Bereiche nur einmal beschichtet werden. Diese entstehende Ungleichmäßigkeit in der Schichtdicke kann als Welligkeit bezeichnet werden.

Die Ausschaltzeit muß also insgesamt sehr viel kleiner sein als die Substrat-Vorschubzeit. Bezeichnet man mit S die Wegstrecke, die von dem Substrat während der Nichtbeschichtungszeit zurückgelegt wird, so gilt, daß die Aus-Zeit, z. B. $t_{an1} - t_{an2}$ << $S/v_{substrat}$ ist. S soll sehr klein sein, damit die Zeit, während der das Substrat beschichtet wird, groß gegen die Aus-Zeit ist. Anders ausgedrückt, soll die Stromversorgung während der Beschichtungszeit sehr oft ein- und ausgeschaltet werden.

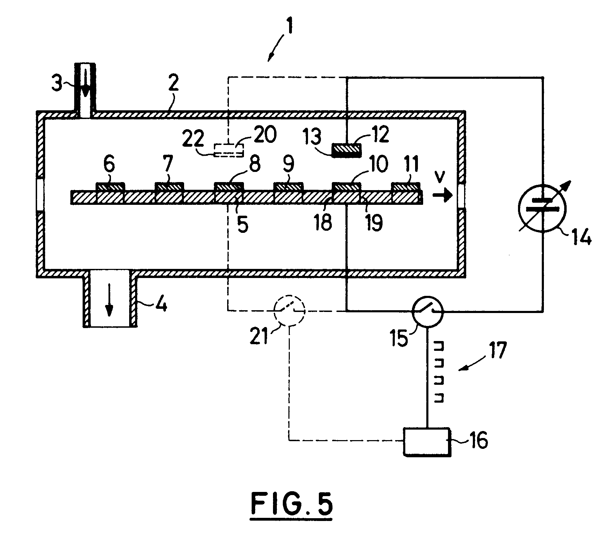

In der Fig. 5 ist schematisch eine Sputteranlage 1 dargestellt, die ein Gehäuse 2 mit einem Gaseinlaß 3 und einem Absaugstutzen 4 für die Erzeugung eines Vakuums im Gehäuse 2 aufweist. In dem Gehäuse ist ein linear beweglicher Träger 5 für mehrere Substrate 6 bis 11 angeordnet, über dem sich eine Kathode 12 mit einem Target 13 befindet.

Die Kathode 12 ist mit dem negativen Pol einer regelbaren Gleichspannunquelle 14 verbunden, deren positiver Pol mit dem Träger 5 in Verbindung steht und somit als Anode wirkt. In dem Stromkreis, der durch die Anoden-Kathoden-Strecke 5, 12 und die Spannungsquelle 14 gebildet wird, befindet sich ein Schalter 15, der von einer Steuereinrichtung 16 getaktet wird. Die Taktimpulse 17 können hierbei bezüglich ihrer Folge und Impulsbreite verändert werden. Ihre Impulsbreite deutet dabei die Dauer an, für die der Schalter 15 geschlossen ist.

Wird der Schalter 15 geschlossen, so verläuft die Spannung zwischen der Anode 5 und der Kathode 12 auf die in der Fig. 1 bzw. der Fig. 4 dargestellte Weise.

Das Substrat 10 wird sich - da sich der Träger 5 mit der Geschwindigkeit v nach rechts bewegt - nur eine bestimmte Zeit unterhalb des Targets befinden. Während dieser Zeit wird die Spannungsquelle 14 beispielsweise 100mal an die Anoden-Kathoden-Strecke gelegt und wieder abgeschaltet, und zwar nach Maßgabe der in den Fig. 1 bis 4 dargestellten Methode.

In dem Gehäuse 2 können selbstverständlich auch mehrere Anoden-Kathoden-Strecken 20 vorgesehen sein, was durch gestrichelte Linien angedeutet ist. Mit Hilfe weiterer Schalter 21 können diese zusätzlichen Kathoden-Anoden-Strecken mit einer anderen Taktfrequenz und einer anderen Impulsbreite getaktet werden. Zusätzliche Targets 22 können sich hinsichtlich ihrer Materialzusammensetzung voneinander unterscheiden.

Die Spannungsquelle bzw. Stromversorgung 14 kann - was im einzelnen nicht dargestellt ist- leistungsgeregelt, stromgeregelt oder spannungsgeregelt sein. Ist sie leistungsgeregelt, wird bei einer Erhöhung des Drucks in der Kammer 2 und bei ungetaktetem Gleichstromsputtern die Spannung sinken und die Stromstarkeansteigen. Die Stromregelung hält den Strom konstant, so daß die Spannung mit ansteigendem Druck starker abfällt. Umgekehrt hält eine Spannungsregelung die Spannung konstant, wobei mit steigendem Druck der Strom ansteigt. In allen drei Fällen wird aber als Regelungsgröße die Spannung an der Kathode verwendet. Je nach Regelungstyp wird die Spannung so verändert bzw. bei Spannungsregelung konstant gehalten, bis der gewählte Sollwert erreicht ist

Alle drei Regelungsarten sind auch bei getakteter Spannung einsetzbar, da auch hier als Regelungsgröße der Spannungswert $U_{soll}$ verwendet wird. Der in der Kammer 2 beschriebene Druck liegt bei Verwendung des Edelgases Argon etwa zwischen $10^{-4}$ mbar und $10^{-2}$ mbar.

Die Sputterkathoden 12, 20 können verschieden groß gewählt werden, wodurch sich bei einer vorgegebenen Brennspannung und Leistungsdichte unterschiedliche Leistungen und Ströme ergeben. So hat beispielsweise eine Kathode von 75 cm Länge und 24 cm Breite bei einer Targetoberfläche von 1800 cm², einer Brennspannung von 500 V und einer Leistungsdichte von 25 W/cm² eine Leistung von 45 kW bei einem Strom von 90 A. Für eine Kathode mit einer Länge von 250 cm, einer Breite von 24 cm und einer Targetoberfläche von

6000 cm$^2$ beträgt die Leistung 150 kW bei einem Strom von 300 A, wobei die Brennspannung 500 V und die Leistungsdichte 25 W/cm$^2$ sind.

Von der herkömmlichen Sputtertechnik, bei welcher der Begriff "Höchstratensputtern" geläufig ist, was bedeutet, daß eine Schichtdicke mit höchster Geschwindigkeit bzw. in kürzester Zeit aufgebaut wird, unterscheidet sich die Erfindung dadurch, daß mit möglichst geringer Rate gesputtert wird, um in einer vorgegebenen Zeit eine dünne Schicht in gewünschter Dicke aufzutragen. Es handelt sich somit um ein "Tiefstratensputtern".

**Patentansprüche**

1. Einrichtung zum Behandeln von Substraten aus einem Plasma, mit wenigstens einer Anode, einer Kathode und einer elektrischen Gleichstrom-Spannunquelle, die impulsweise an die Anoden-Kathoden-Strecke anschließbar ist, **dadurch gekennzeichnet**, daß die Dauer der Spannungsimpulse und/oder der Abstand zwischen den Impulsen regelbar ist.

2. Einrichtung nach Anspruch 1, **dadurch gekennzeichnet**, daß das Substrat (10) relativ zu einer Kathode (12, 20) bewegbar ist

3. Einrichtung nach Anspruch 1, **dadurch gekennzeichnet**, daß der Abstand zwischen zwei Spannungsimpulsen wenigstens $t_z$ + $t_p$ beträgt, wobei $t_z$ die nach dem Einschalten einer Versorgungsspannung erforderliche Zeit zum Zünden eines Plasmas und $t_p$ eine Konstante ist.

4. Einrichtung nach Anspruch 3, **dadurch gekennzeichnet**, daß $t_z$ + $t_p$ etwa 1 $\mu$s bis 12 $\mu$s beträgt.

5. Einrichtung nach Anspruch 1, **dadurch gekennzeichnet**, daß der Abstand zwischen zwei Spannungsimpulsen $t_z$ + $t_p$ + $t_{verz}$ beträgt, wobei $t_{verz}$ eine variable Verzögerungszeit ist, die zu Regelzwecken verwendet wird.

6. Einrichtung nach Anspruch 1, **dadurch gekennzeichnet**, daß die Kathode (12) mit einem Target (13) versehen ist, das zerstäubt wird.

7. Einrichtung nach Anspruch 1, **dadurch gekennzeichnet**, daß mehrere Kathoden (12, 20) in einer Ebene angeordnet sind.

8. Einrichtung nach Anspruch 6, **dadurch gekennzeichnet**, daß die Kathoden (12, 20) jeweils verschiedene Targets (13, 22) aufweisen.

9. Einrichtung nach Anspruch 1, **dadurch gekennzeichnet**, daß die Zeit zwischen zwei Impulsen sehr klein gegenüber der Zeit ist, die das Substrat (10) benötigt, um sich an der Elektrode (12) vozbeizubewegen.

FIG.1

FIG.2

Impuls „SSV-ein-/ausschalten"

FIG.3

**FIG. 4**

## FIG.5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,X<br>D,A | DE-A-3 700 633 (GRÜN)<br>* Zusammenfassung *<br>* Spalte 6, Zeile 23 – Spalte 7, Zeile 19 *<br>* Spalte 7, Zeile 45 – Zeile 54 *<br>* Spalte 8, Zeile 2 – Zeile 8 *<br>* Spalte 8, Zeile 32 – Zeile 48; Abbildungen 2,3,5 *<br>--- | 1<br>3-6 | H01J37/34<br>C23C14/34 |
| P,X<br>P,A | WO-A-9 112 628 (KLÖCKNER IONON GMBH)<br>* Zusammenfassung *<br>* Seite 1, Absatz 5 – Seite 3, Absatz 4; Ansprüche 1-7; Abbildungen 1,2 *<br>& DE-A-4 003 623 (KLÖCKNER IONON GMBH)<br>--- | 1<br>3-5 | |
| A | DE-A-3 248 121 (LEYBOLD HERAEUS)<br>* Zusammenfassung *<br>* Ansprüche 1,2; Abbildungen 1,2 *<br>--- | 2,7,8 | |
| A | EP-A-0 432 090 (BALZERS AG)<br>* Spalte 3, Zeile 9 – Spalte 5, Zeile 8; Ansprüche 1-3; Abbildung 3 *<br><br>----- | 1 | **RECHERCHIERTE SACHGEBIETE (Int. Cl.5)**<br><br>H01J<br>C23C |

Der vorliegende Recherchenbericht wurde für alle Patentansprüche erstellt

| Recherchenort | Abschlußdatum der Recherche | Prüfer |
|---|---|---|
| DEN HAAG | 13 NOVEMBER 1992 | GREISER N. |

EPO FORM 1503 03.82 (P0403)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................
& : Mitglied der gleichen Patentfamilie, übereinstimmendes Dokument